# EUROPEAN PATENT SPECIFICATION

(11) **EP 3 622 611 B1**
(45) Date of publication and mention of the grant of the patent: **17.02.2021**
(21) Application number: 18720241.1
(22) Date of filing: 25.04.2018
(51) Int. Cl.: H02J 9/06, H03K 17/13

(54) **METHOD FOR FORCING THE COMMUTATING OF A BYPASS SCR OF A UPS SYSTEM AND UPS SYSTEM**
VERFAHREN ZUM ZWANG DER KOMMUTIERUNG EINES BYPASS-SCRS EINES UPS SYSTEMS UND UPS SYSTEM
PROCÉDÉ POUR FORCER LA COMMUTATION D'UN SCR SHUNTÉ DANS UN SYSTÈME D'ALIMENTATION SANS INTERRUPTION ET SYSTÈME D'ALIMENTATION SANS INTERRUPTION

(30) Priority: 08.05.2017 GB 201707303
(43) Date of publication of application: 18.03.2020
(73) Proprietor: Eaton Intelligent Power Limited, Dublin 4 (IE)
(72) Inventor: SJÖBERG, Anders, 02760 Espoo (FI); KOHTAMÄKI, Tuomo, 00530 Helsinki (FI); PAAKKUNAINEN, Teemu, 08500 Lohja (FI)
(74) Representative: Eaton IP Group EMEA
(86) International application number: PCT/EP2018/060617
(87) International publication number: WO 2018/206293

(56) References cited:
- WO-A2-2014/041523

## Description

### TECHNICAL FIELD

The invention relates to an improvement of a UPS (Uninterruptible Power Supply) system, particularly to forcing the commutating of the bypass SCR (Silicon Controlled Rectifier) in a UPS system.

### BACKGROUND

When a UPS system operates in a so-called Eco mode, the load is supplied with power from the mains (electric power) via a static bypass switch. This switch comprises two anti-parallel connected thyristors or SCRs, respectively, per phase of the mains. These (bypass) SCRs operate as switches for controlling whether to supply or not to supply a load connected to the UPS system directly from the mains.

When an outage of the mains supply occurs, for example when the mains supply deteriorates outside acceptable limits, the SCR drive signals are switched off by the UPS system processor. Due to the electrical characteristics of a SCR it will not switch off (commutate) immediately but will keep on conducting until the forward current is practically zero. In most cases this is close to phase voltage zero crossing resulting in a commutation delay of several milliseconds, particularly up to 10 milliseconds in a 50 Hertz power supply system.

While the SCR is still conducting, any disturbance upstream of the UPS system will be seen on the output (load) side of the UPS system although the inverter of the UPS system is already running. In the worst case the mains failure mode upstream of the UPS system is a low impedance or a complete short circuit causing the output voltage of the UPS system to collapse until the SCR has naturally commutated, i.e. a zero crossing of the SCR current occurred.

Essentially this may mean a worst-case outage of several milliseconds on UPS system output when transferring from Eco mode to double conversion mode. Some UPS system loads or system configurations are too sensitive for this kind of outage and thus an improvement in output voltage response time is desirable.

The international patent application WO2014/041523A2 describes a UPS system that is switchable between a higher efficiency mode and a low efficiency mode. The higher efficiency mode is either a VFD (Voltage and Frequency of the Output are Dependent on the Input) mode or a VI (Voltage of the Output is Independent of Input) mode. The lower efficiency mode is a VFI (Voltage and Frequency of the Output are Independent of Input Voltage and Frequency) mode, has a bypass switch with thyristors. The UPS system has an inverter and a controller. An inductor is connected in series between the thyristors and a secondary power source. When an undervoltage is detected on the secondary power source, the UPS system is switched from the higher efficiency mode, either the VFD mode or VI mode, to the VFI mode. In switching the UPS system to the VFI mode, the controller synchronizes thyristor gate commands for the thyristors with the reserve voltage, and a slightly leading phase compensation introduced by the inverter. If all the load currents are not in phase with a fundamental voltage of the secondary power source, the controller waits up to a first period of time in order to estimate when a current through a thyristor corresponding to the out of phase current will reach zero. Should this estimation determine that the out of phase current will reach zero by the end of a second period of time, the corresponding inverter phase is switched on at the end of the second period of time. However, if the estimation determines that the current will take more than the second period of time to reach zero, at the end of the first period of time the controller controls the applicable phase of the inverter for the second time period to provide a counter voltage in order to attempt to turn off the applicable thyristor. The inductor limits the current in the inverter phase being operated to provide the counter voltage while that inverter phase generates the counter voltage to un-polarize the applicable thyristor. After the end of the second time period, the controller operates the inverter to provide the nominal voltage waveform.

### SUMMARY OF INVENTION

It is an object of the present invention to improve a UPS system.

This object is achieved by the subject matter of the independent claims. Further embodiments are shown by the dependent claims.

The present invention proposes an acceleration of the switching off a bypass SCR in a UPS system by forcing the commutating of the bypass SCR with an inversion of the UPS inverter output polarity for a predetermined time interval. Thus, a reverse current from the bypass SCR is drawn by the UPS inverter output and can be extinguished in a usually much shorter time than the time until zero crossing (typically microseconds versus milliseconds). In addition, the reversed inverter polarity may sink "kickback" current from the load side, which may prevent it to keep the bypass SCR in a switched-on state. This allows to apply the invention also effectively with regenerative loads.

An embodiment of the invention relates A method for forcing the commutating of a bypass silicon controlled rectifier - SCR - of an uninterruptible power supply - UPS - system comprising a sequence of the following steps:
a) detecting an outage of a mains supply of the UPS system,
b) turning on an inverter of the UPS system with a normal output polarity, wherein the inverter is capable to switch into an output current limitation mode in which its output current is limited and to generate a signal when switched into the output current limitation mode,
c) switching off the bypass SCR and thereafter determining if and how long the inverter is operated in the output current limitation mode, and if it is determined that the inverter operation in the output current limitation mode exceeds a predetermined time span then performing the following steps:
d) turning off the inverter, and
e) turning on the inverter with a reverse output polarity for a predetermined time interval so that a reverse current is drawn via the bypass SCR.

The predetermined time interval in step e) varies depending on the frequency of the power supply system in which the UPS system is operated etc., but may be for instance about 1 to about 2 milliseconds, particularly about 2 milliseconds, in case of a UPS system operated in a 50 Hertz power supply system.

The method may comprise the following further step:
f) turning on the inverter with the normal polarity after a further predetermined time interval.

The further predetermined time interval is preferably about 0,3 milliseconds.

A further embodiment of the invention relates to an uninterruptible power supply - UPS - system comprising
a bypass silicon controlled rectifier - SCR - per phase connected between a mains supply input and a mains supply output of the UPS system,
an inverter having a Direct Current - DC input connectable to a battery and an Alternating Current - AC - output connected to the mains supply output of the UPS system, wherein the output polarity of the AC output can be switched between a normal and a reverse output polarity, wherein the inverter operates as a current source with its AC output being switched in normal output polarity and as a current sink with its AC output being switched in reverse output polarity, and wherein the inverter is capable to switch into an output current limitation mode in which its output current is limited and to generate a signal when switched into the output current limitation mode, and
a processor being configured to switch on and off the bypass SCRs and to turn on and off the inverter and to control the inverter's output polarity, wherein the processor is further configured to perform a method of the invention and as described herein.

The SCR particularly comprise two antiparallel connected thyristors with the gate of each thyristor controlled by the processor.

These and other aspects of the invention will be apparent from and elucidated with reference to the embodiment(s) described hereinafter.

The invention will be described in more detail hereinafter with reference to the exemplary embodiment(s). However, the invention is not limited to the exemplary embodiment(s).

### BRIEF DESCRIPTION OF DRAWINGS

Fig. 1 shows a block diagram of a UPS circuitry with a bypass SCR and an inverter in a normal operation state with indicated current flow;
Fig. 2 shows the UPS circuitry of Fig. 1 in a state, where an upstream fault appeared, and the indicated current flow in this fault state;
Fig. 3 shows the UPS circuitry of Fig. 1 in a state, where the inverter is operated with inverse output polarity during a brief time interval during the upstream fault, and the indicated current flow in this inverter forced commutation state, according to the invention;
Fig. 4 shows the UPS circuitry of Fig. 1 in a state, where the inverter is operated with normal output polarity after the bypass SCR was switched off by the forced commutation according to the invention;
Fig. 5 shows a timing diagram with signals generated by a UPS system processor configured to perform a method for forcing the commutating of a bypass SCR of a UPS system according to the invention.

### DESCRIPTION OF EMBODIMENTS

In the following, functionally similar or identical elements may have the same reference numerals. Absolute values are shown below by way of example only and should not be construed as limiting the invention.

Briefly summarized, the present invention may be applied to existing UPS inverter hardware to force commutating the static bypass SCR for an improved output response, as will be explained thereafter in detail with reference to an embodiment of the invention.

In the following, the operation sequence of the forced commutation according to the invention is explained by means of an actual use case and with reference to the accompanying drawings.

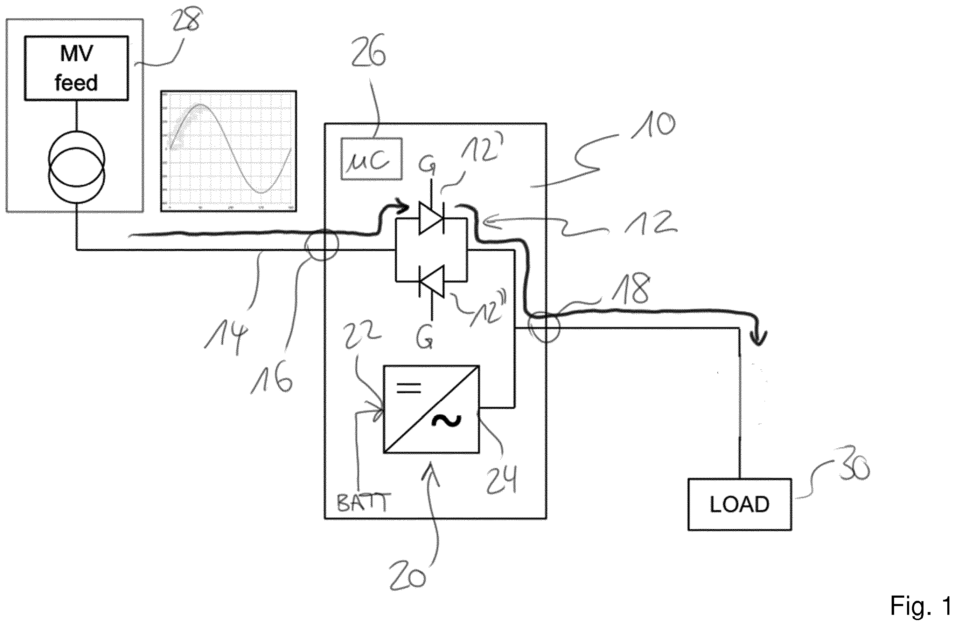

Figs.1 to 4 show a block diagram of an embodiment of a UPS system 10 having a mains supply input 16 and a mains supply output 18. The mains supply input 16 is connected to the phases 14 of a mains power supply 28. The phases of a power supply line of a load 30 is connected to the mains supply output 18 of the UPS system 10. Static bypass SCRs 12 for each mains phase are switched between the mains supply input 16 and the mains supply output 18 and allow (dis)connecting the load 230 with the phases 14 of the mains power supply 28.

The static bypass SCRs 12 are controlled by a microcontroller 26, which is configured to monitor the phases 14 of the mains power supply 28 for detecting an outage and to control the switching on and off the static bypass SCRs 12 depending on an outage detection.

The UPS system 10 further comprises an inverter 20 for converting DC (Direct Current) from a battery BATT connected to its DC input 22 into AC (Alternating Current) supplied to the mains supply output 18 via its AC output 24. The operation of the inverter 20 is controlled by the microcontroller 26.

In normal operation of Eco mode as shown in Fig. 1, the load 30 is supplied via static bypass SCR 12 from the phases 14 of the mains power supply 28. The inverter 20 parallel to the static bypass SCR 12 is on standby mode and ready to start supplying the load 30 with AC when the mains power supply 28 condition deteriorates outside acceptable limits (outage condition).

The static bypass SCR 12 comprises two antiparallel thyristors 12', 12" that both have their function to conduct current - one towards the load 30 and other backwards in the mains power supply 28. The drawback of the SCR 12 is that it cannot be turned off (commutated) instantaneously just by removing the control signal at the gates G of the thyristors 2', 12". The SCR 12 will only commutate when the forward current in each thyristor 12', 12" is reduced to zero. For example, when supplying an AC load in a 4 wire 50 Hertz system (3 phases + 1 neutral phase) the current zeroing happens every 10 milliseconds. In such a system, this timing dictates the worst-case SCR commutation time of about 10 milliseconds when naturally commutating the SCR.

For the example shown in Fig. 1, it is assumed that the upper thyristor 12' to be conducting and voltage and current to be in same phase, as it is indicated by the thick arrows indicating the current flow.

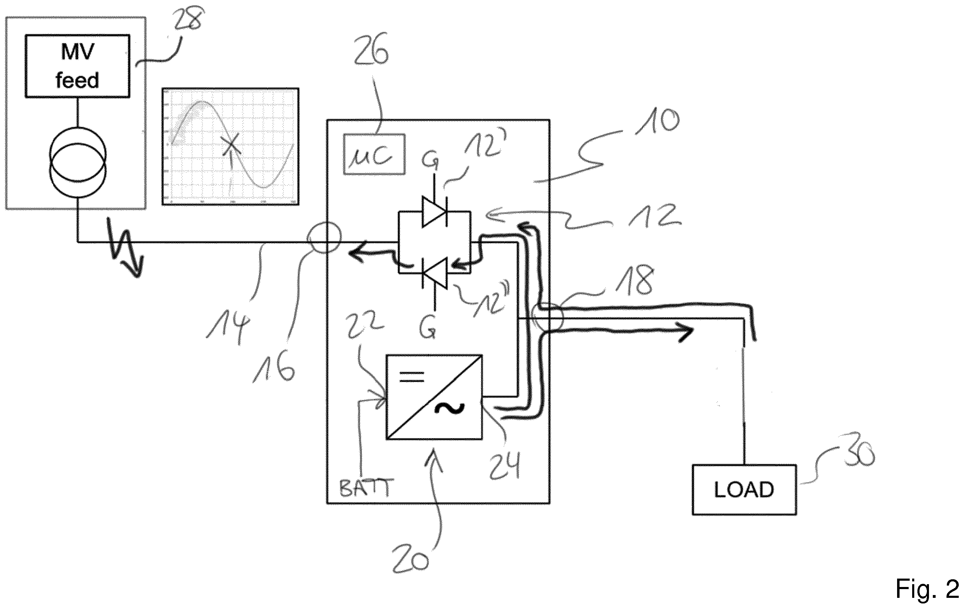

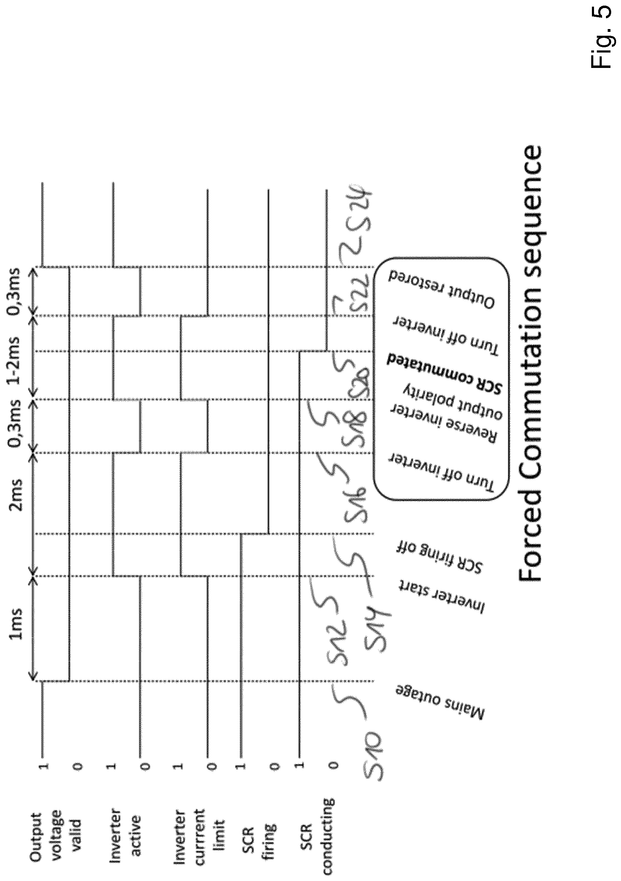

During operation of the UPS system 10, the microcontroller 26 monitors the condition of the phases 14 of the mains power supply 28 to detect a fault. When a fault appears to the supplying network as shown in Fig. 2 and indicated by the flash, for example an upstream short circuit between phases 14 or an outage of the mains power supply 28, the microcontroller 26 detects the fault (signal "Output voltage valid" and fault detection at S10 in Fig. 5) and starts the standby inverter 20 for supplying the load after a short time span of for example 1 millisecond (signal "Inverter active" at S12 in Fig. 5) while the static bypass SCR 12 is still being fired (control signal "SCR firing" in Fig. 5 given from the microcontroller 26 to the SCR 12 to conduct).

This causes the upper thyristor 12' of the SCR 12 to commutate but at the same time the lower thyristor 12" will lit up due to the "SCR firing" signal still being present. This causes the inverter 20 to feed AC current to the upstream fault, refer to Fig. 2 and the bold arrows indicating the current flow from the AC output 24 of the inverter 20 and the load 30 to the phases 14 via the still conducting thyristors 12". If the fault in the mains power supply 28 is a typical low impedance fault, the output voltage of the inverter would likely collapse until the thyristor 12" of the SCR 12 commutates naturally on the next zero crossing. The small waveform diagram in Fig. 2 shows a typical AC current waveform on the phases 14; the zero crossing is marked by a cross in the diagram; if an outage is detected at the beginning of the first half period of the waveform, it can take up to 10ms in a 50 Hertz system in worst case. A voltage collapse lasting up to 10ms would also be present to the load 30 and could cause severe issues to sensitive loads.

According to the idea underlying the present invention, the inverter 20 is used to zero down the current flowing through the lower thyristor 12" of the SCR 12 and thus force commutating the thyristor 12" sooner than the average time span until zero crossing, for example 10 milliseconds, which results in a better output performance and allows use of more sensitive loads in the Eco mode of the UPS system 10. This is described in details in the following.

Once the inverter 20 has started up to feed the load 30 (and upstream fault, as shown in Fig. 2), the UPS system 10, particularly the microcontroller 26 will make the decision whether to keep firing the SCR 12 or to stop SCR firing (signal "SCR firing" in Fig. 5). This detection refers to upstream / downstream fault detection. In an upstream fault condition, such as shown in Fig. 2, the UPS system 10 decides to stop the SCR firing (signal "SCR firing" going from 1 to 0 at S14 in Fig. 5).

Here begins the method of forced commutation according to the invention.

After starting the inverter 20 by the microcontroller 26 with the signal "Inverter active" (at S12 in Fig. 5), the inverter 20 feeds the load 30 and the upstream fault which will cause the inverter 20 to reach the inverter output current limitation mode (signal "Inverter current limit" generated by the inverter 20 changes from 0 to 1 at S12 in Fig. 5).

When this output current limitation is active for long enough time after the SCR firing stopped at S14 in Fig. 5 (for example 1 to 2 milliseconds), the UPS system 10, particularly the microcontroller 26 can decide that the current limit condition is not caused by the load 30, but by an upstream fault, and the SCR 12 is not being commutated naturally. This situation can be detected by the microcontroller 26 by measuring the time span from the switching of the signal "Inverter current limit" received by the microcontroller 26. For example, if the microcontroller 26 detects a state change of the signal "Inverter current limit" and after the SCR firing has been stopped, it may start an internal timer until a further state change of the signal "Inverter current limit" is detected. If the timer count exceeds a predetermined value corresponding to for example a typical value of 2 milliseconds in a 50 Hertz power supply system, then the microcontroller 26 can set a flag "upstream fault".

The set flag may indicate the condition of an upstream fault requiring a forced commutation of the SCR 12. Once this condition is fulfilled, the microcontroller 26 can first stop the inverter 20 for a short time of for example 0,3 milliseconds (signal "Inverter active" goes from 1 to 0 at S16 in Fig. 5) and then can invert the output polarity of the inverter 20.

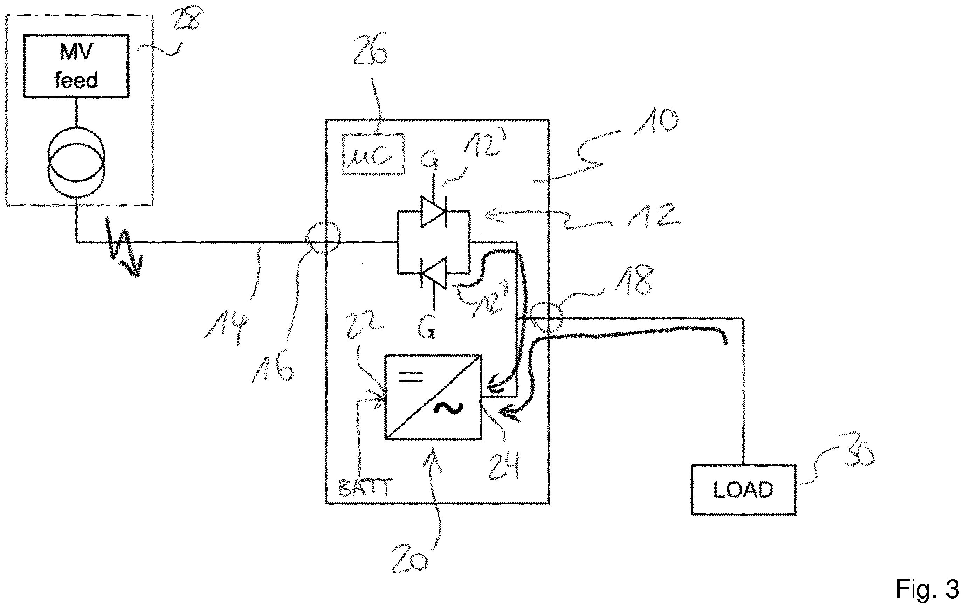

Thereafter, the microcontroller 26 shall restart inverter 20 but in opposite voltage (signal "Inverter active" goes from 0 to 1 at S18 in Fig. 5). This will cause the current going through the SCR 12 to change direction as the inverter 20 is now sinking the current (including the possible energy coming from regenerative loads, such as motors; refer to Fig. 3, in which the current flow is indicated by the bold arrows) causing the SCR 12 current to go to zero and commutate the thyristor 12" of the SCR 12 (signal "SCR conducting" goes from 1 to 0 at S20 in Fig. 5).

The inverted voltage operation of the inverter 20 continues for a predetermined time interval (adjustable based on actual lab tests; for example, 0,5 to 2 milliseconds). This is followed by a short complete stop in inverter operation initiated by the microcontroller 26 by switching the signal "Inverter active" from 1 to 0 at S22.

The elegance in the inverter output polarity change is that the UPS control does not need to know in which phase the output voltage or current is. If the inverter sees an output current limitation it means that one of the antiparallel SCRs is conducting and reversing the inverter output voltage will cause current flow in opposite direction and result in a forced commutation according to the invention.

The inverter output voltage inversion may happen selectively in each output phase (if for example a 3-phase system is used), i.e. in only in those phases where the inverter sees an active current limit condition.

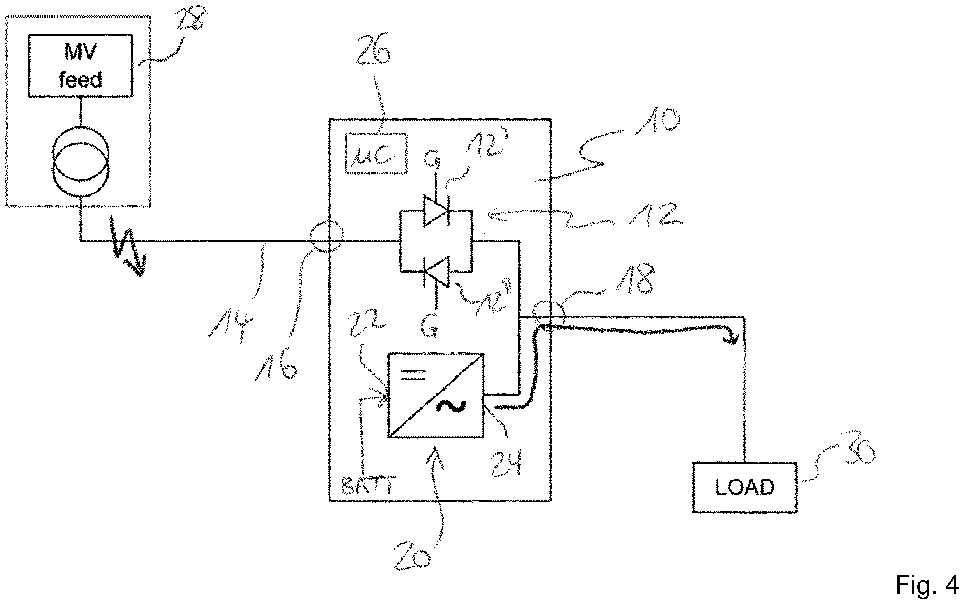

After the stop of the inverter 20 of for example 0,3ms, the microcontroller 26 restores the inverter output to normal polarity and turns the inverter 20 on for normal operation to supply the load 30 - as the SCR 12 has been forced to commutate in the previous steps. In Fig. 4, the inverter 20 is in normal operation with the current flow indicated by the bold arrow from the AC output 24 of the inverter 20 to the load 30.

The above-mentioned operation times are only example times.

By the inventive operation sequence, a UPS can achieve a very low output response time such as low as few milliseconds to an upstream fault (low impedance/short circuit). This is considerably less of the time that conventional natural commutation cycle requires.

At least some of the functionality of the invention may be performed by hard- or software. In case of an implementation in software, a single or multiple standard microprocessors or microcontrollers may be used to process a single or multiple algorithms implementing the invention.

It should be noted that the word "comprise" does not exclude other elements or steps, and that the word "a" or "an" does not exclude a plurality. Furthermore, any reference signs in the claims shall not be construed as limiting the scope of the invention.

## Claims

1. A method for forcing the commutating of a bypass silicon controlled rectifier - SCR - of an uninterruptible power supply - UPS - system comprising a sequence of the following steps:
a) detecting an outage of a mains supply of the UPS system (S10),
b) turning on an inverter of the UPS system with a normal output polarity (S12), wherein the inverter is capable to switch into an output current limitation mode in which its output current is limited and to generate a signal when switched into the output current limitation mode,
c) switching off the bypass SCR (S14) and thereafter determining if and how long the inverter is operated in the output current limitation mode, and if it is determined that the inverter operation in the output current limitation mode exceeds a predetermined time span then performing the following steps:
d) turning off the inverter (S16), and
e) turning on the inverter with a reverse output polarity for a predetermined time interval so that a reverse current is drawn via the bypass SCR (S18).

2. The method of claim 1, wherein the predetermined time interval in step e) is about 1 to about 2 milliseconds, particularly about 2 milliseconds.

3. The method of claim 1 or 2, comprising the following further step:
f) turning on the inverter with the normal polarity after a further predetermined time interval.

4. The method of claim 3, wherein the further predetermined time interval is about 0,3 milliseconds.

5. An uninterruptible power supply - UPS - system (10) comprising
- a bypass silicon controlled rectifier - SCR - (12) per mains phase (14) connected between a mains supply input (16) and a mains supply output (18) of the UPS system (10),
- an inverter (20) having a Direct Current - DC input (22) connectable to a battery and an Alternating Current - AC - output (24) connected to the mains supply output (18) of the UPS system (10), wherein the output polarity of the AC output (24) can be switched between a normal and a reverse output polarity, wherein the inverter (20) operates as a current source with its AC output (24) being switched in normal output polarity and as a current sink with its AC output (24) being switched in reverse output polarity, and wherein the inverter is capable to switch into an output current limitation mode in which its output current is limited and to generate a signal when switched into the output current limitation mode, and
- a processor (26) being configured to switch on and off the bypass SCRs (12) and to turn on and off the inverter (20) and to control the inverter's output polarity, wherein the processor (26) is further configured to perform the method of any of the preceding claims.

6. The UPS system of claim 5, wherein the SCR (12) comprises two antiparallel connected thyristors (12', 12") with the gate (G) of each thyristor controlled by the processor (26).

## Patentansprüche

1. Verfahren zum Erzwingen der Kommutierung eines siliziumgesteuerten Bypass-Gleichrichters (bypass silicon controlled rectifier, Bypass-SCR) eines unterbrechungsfreien Stromversorgungs (USV)-Systems umfassend eine Abfolge der folgenden Schritte:
a) Erkennen eines Ausfalls der Netzversorgung des USV-Systems (S10);
b) Einschalten eines Wechselrichters des USV-Systems mit einer normalen Ausgangspolarität (S12), wobei der Wechselrichter in der Lage ist, in einen Ausgangsstrombegrenzungsmodus zu schalten, in dem sein Ausgangsstrom begrenzt ist, und ein Signal zu erzeugen, wenn er in den Ausgangsstrombegrenzungsmodus geschaltet wird;
c) Abschalten des Bypass-SCR (S14) und danach Feststellen, ob und wie lange der Wechselrichter im Ausgangsstrombegrenzungsmodus betrieben wird, und wenn festgestellt wird, dass der Wechselrichterbetrieb im Ausgangsstrombegrenzungsmodus eine vorgegebene Zeitspanne überschreitet, dann Ausführen der folgenden Schritte:
d) Ausschalten des Wechselrichters (S16), und
e) Einschalten des Wechselrichters mit einer umgekehrten Ausgangspolarität für ein vorbestimmtes Zeitintervall, so dass über den Bypass-SCR (S18) ein Rückstrom gezogen wird.

2. Verfahren nach Anspruch 1, wobei das vorgegebene Zeitintervall in Schritt e) etwa 1 bis etwa 2 Millisekunden, insbesondere etwa 2 Millisekunden, beträgt.

3. Verfahren nach Anspruch 1 oder 2, umfassend den folgenden weiteren Schritt:
f) Einschalten des Wechselrichters mit der normalen Polarität nach einem weiteren vorgegebenen Zeitintervall.

4. Verfahren nach Anspruch 3, wobei das weitere vorgegebene Zeitintervall etwa 0,3 Millisekunden beträgt.

5. Unterbrechungsfreies Stromversorgungs (USV)-System (10), umfassend
- einen siliziumgesteuerten Bypass-Gleichrichter - SCR - (12) pro Netzphase (14), der zwischen einen Netzversorgungseingang (16) und einen Netzversorgungsausgang (18) des USV-Systems (10) geschaltet ist,
- einen Wechselrichter (20) mit einem Gleichstrom (DC)-Eingang (22), der mit einer Batterie verbindbar ist und einem Wechselstrom (AC)-Ausgang (24), der mit dem Netzversorgungsausgang (18) des USV-Systems (10) verbunden ist, wobei die Ausgangspolarität des Wechselstrom-Ausgangs (24) zwischen einer normalen und einer umgekehrten Ausgangspolarität umgeschaltet werden kann, wobei der Wechselrichter (20) als eine Stromquelle arbeitet, wenn sein Wechselstromausgang (24) in normaler Ausgangspolarität geschaltet ist, und als eine Stromsenke arbeitet, wenn sein Wechselstromausgang (24) in umgekehrter Ausgangspolarität geschaltet ist, und wobei der Wechselrichter in der Lage ist, in einen Ausgangsstrombegrenzungsmodus zu schalten, in dem sein Ausgangsstrom begrenzt ist, und ein Signal zu erzeugen, wenn er in den Ausgangsstrombegrenzungsmodus geschaltet wird, und
- einen Prozessor (26), der konfiguriert ist, um die Bypass-SCRs (12) ein- und auszuschalten und den Wechselrichter (20) ein- und auszuschalten und die Ausgangspolarität des Wechselrichters zu steuern, wobei der Prozessor (26) ferner konfiguriert ist, um das Verfahren nach einem der vorstehenden Ansprüche auszuführen.

6. USV-System nach Anspruch 5, wobei der SCR (12) zwei antiparallel geschalteten Thyristoren (12', 12") umfasst, wobei das Gate (G) jedes Thyristors durch den Prozessor (26) gesteuert wird.

## Revendications

1. Procédé pour forcer la commutation d'un redresseur commandé au silicium - SCR - de dérivation d'un système d'alimentation électrique sans interruption - UPS - dont la séquence d'étapes consiste à :
a) détecter une coupure d'une alimentation en courant secteur du système UPS (S10),
b) activer un onduleur du système UPS avec une polarité de sortie normale (S12), l'onduleur étant capable de commuter dans un mode de limitation de courant de sortie dans lequel son courant de sortie est limité et de générer un signal lorsqu'il est commuté dans le mode de limitation de courant de sortie,
c) désactiver le SCR de dérivation (S14) et ensuite déterminer si et combien de temps l'onduleur fonctionne dans le mode de limitation de courant de sortie, et s'il est déterminé que le fonctionnement de l'onduleur dans le mode de limitation de courant de sortie dépasse une durée prédéterminée, exécuter les étapes suivantes :
d) désactiver l'onduleur (S16), et
e) activer l'onduleur avec une polarité de sortie inverse pendant un intervalle de temps prédéterminé de telle sorte qu'un courant inverse soit absorbé via le SCR de dérivation (S18).

2. Procédé selon la revendication 1, dans lequel l'intervalle de temps prédéterminé à l'étape e) est d'environ 1 à environ 2 millisecondes, plus particulièrement d'environ 2 millisecondes.

3. Procédé selon la revendication 1 ou 2, comprenant l'étape supplémentaire suivante :
f) activer l'onduleur avec la polarité normale après un intervalle de temps prédéterminé supplémentaire.

4. Procédé selon la revendication 3, dans lequel l'intervalle de temps prédéterminé supplémentaire est d'environ 0,3 milliseconde.

5. Système d'alimentation électrique sans interruption - UPS - (10) comprenant
- un redresseur commandé au silicium - SCR - de dérivation (12) par phase de courant secteur (14) connecté entre une entrée d'alimentation en courant secteur (16) et une sortie d'alimentation en courant secteur (18) du système UPS (10),
- un onduleur (20) ayant une entrée en courant continu - DC - (22) pouvant être connectée à une batterie et une sortie en courant alternatif - AC - (24) connectée à la sortie d'alimentation en courant secteur (18) du système UPS (10), dans lequel la polarité de sortie de la sortie AC (24) peut être commutée entre une polarité de sortie normale et une polarité de sortie inverse, dans lequel l'onduleur (20) fonctionne comme une source de courant avec sa sortie AC (24) commutée en polarité de sortie normale et comme un récepteur de courant avec sa sortie AC (24) commutée en polarité de sortie inverse, et dans lequel l'onduleur est capable de commuter dans un mode de limitation de courant de sortie dans lequel son courant de sortie est limité et de générer un signal lorsqu'il est commuté dans le mode de limitation de courant de sortie, et
- un processeur (26) configuré pour activer et désactiver les SCR de dérivation (12) et activer et désactiver l'onduleur (20) et pour commander la polarité de sortie de l'onduleur, dans lequel le processeur (26) est en outre configuré pour exécuter le procédé selon l'une quelconque des revendications précédentes.

6. Système UPS selon la revendication 5, dans lequel le SCR (12) comprend deux thyristors connectés en antiparallèle (12', 12"), la grille (G) de chaque thyristor étant commandée par le processeur (26).
